# EUROPEAN PATENT SPECIFICATION

(11) **EP 3 805 293 B1**
(45) Date of publication and mention of the grant of the patent: **17.09.2025**
(21) Application number: 19811496.9
(22) Date of filing: 31.05.2019
(51) Int. Cl.: C08L 53/02, C08L 25/16, C08L 79/00, C08L 71/10, C08J 5/24, B32B 15/082, B32B 25/14, B32B 27/04, B32B 27/30, C08K 3/013, C08K 5/315, C08K 5/3415, H05K 1/03

(54) **RESIN COMPOSITION, PREPREG, METAL FOIL-CLAD LAMINATE, RESIN SHEET, AND PRINTED WIRING BOARD**
HARZZUSAMMENSETZUNG, PREPREG, METALLFOLIENVERKLEIDETES LAMINAT, HARZFOLIE UND LEITERPLATTE
COMPOSITION DE RÉSINE, PRÉIMPRÉGNÉ, STRATIFIÉ RENFORCÉE PAR UNE FEUILLE MÉTALLIQUE, FEUILLE DE RÉSINE ET CARTE DE CIRCUIT IMPRIMÉ

(30) Priority: 01.06.2018 JP 2018105995
(43) Date of publication of application: 14.04.2021
(73) Proprietor: MITSUBISHI GAS CHEMICAL COMPANY, INC., Chiyoda-ku Tokyo 100-8324 (JP)
(72) Inventor: HIGASHITA Kazuyuki, Tokyo 125-8601 (JP); YAMAMOTO Katsuya, Tokyo 125-8601 (JP); HONDA Saori, Tokyo 125-8601 (JP); UENO Yoshitaka, Shirakawa-gun, Fukushima 961-8031 (JP)
(74) Representative: Hoffmann Eitle
(86) International application number: PCT/JP2019/021692
(87) International publication number: WO 2019/230943

(56) References cited:
- EP-A1- 3 290 480
- WO-A1-2017/209108
- JP-A- H01 158 039
- JP-A- S56 157 454
- JP-A- S57 185 350
- JP-A- S58 164 639
- US-A1- 2009 110 938
- US-A1- 2013 075 138
- US-A1- 2015 017 449

## Description

### Technical Field

The present invention relates to a resin composition, a prepreg, a resin sheet, and metal foil-clad laminate that are useful as printed wiring board materials, and a printed wiring board.

### Background Art

In recent years, information terminal devices, such as personal computers and servers, and communication devices, such as Internet routers and optical communications, have been required to process large amounts of information at high speed, and high speed and high frequency of electrical signals have been advancing. Along with this trend, to accommodate the request for high frequency, laminates for printed wiring boards used in these devices have been required to have a lower dielectric constant and a lower dielectric loss tangent.

Furthermore, the laminates have been required to have improved chemical resistance. The reason for the requirement is that the laminates are exposed to various chemical solutions in the processes of producing laminates for printed wiring boards, such as etching, desmear, and plating, and thus low chemical resistance of the laminates reduces quality and productivity of the laminates.

Specifically, this is because a laminate with insufficient chemical resistance causes a resin layer in the laminate to dissolve into a chemical solution and contaminate the chemical solution, and the use of the contaminated solution leads to a problem of reduced quality of the laminate.

In particular, in desmearing, a strong alkaline chemical is used to remove a smear caused by mechanical drilling or laser drilling, and thus in a laminate with insufficient chemical resistance, surfaces of a through-hole inner wall or a plastic layer are also dissolved along with the smear, leading to contaminate the chemical solution relatively easily.

On the other hand, to achieve a low dielectric constant and a low dielectric loss tangent, a resin material containing a styrene-based elastomer is used as an insulating layer between wirings multilayered in a printed wiring board. Styrene-based elastomers are compounds that have excellent electrical properties (a low dielectric constant and low dielectric loss tangent) and are expected to be effective in increasing transmission speed and reducing transmission loss. To improve performance of printed wiring boards and to multilayer printed wiring boards, attempts have been made to apply a laminate of prepregs formed using this styrene-based elastomer to a printed wiring board (Patent Documents 1 to 3).

Patent document 4 describes a cyanate ester-based curable resin composition suitably used for molding materials, laminated plates as prepregs, adhesives, structural materials, paints, solvent-free liquid casting resins and various other uses.

### Citation List

### Patent Documents

Patent Document 1: JP 6167621 B
Patent Document 2: JP 6136348 B
Patent Document 3: JP 2011-001411 A
Patent Document 4: JP 01-158039

### Summary of Invention

### Technical Problem

However, styrene-based elastomers typically have poor miscibility with resins and thus have a disadvantage in that the styrene-based elastomer itself may peel off during treatment with a chemical solution.

Objects of the present invention are to provide a resin composition that can form a printed wiring board with a low dielectric constant and dielectric loss tangent and excellent alkali resistance and desmear resistance, and to provide a prepreg, a resin sheet, a metal foil-clad laminate, and a printed wiring board formed using this resin composition.

### Solution to Problem

As a result of diligent research on the above problems, the present inventors found that the use of a resin composition containing a styrene-based elastomer, a styrene oligomer, a maleimide compound, and a cyanate ester compound as claimed can solve the above problems and completed the present invention.

That is, the present invention is as defined in the attached claims.
(1) A resin composition containing a styrene-based elastomer (A), a styrene oligomer (B), a maleimide compound (C), and a cyanate ester compound (D)., wherein the styrene-based elastomer (A) is at least one selected from the group consisting of a styrene-butadiene-styrene block copolymer, a styrene-isoprene-styrene block copolymer, a styrene-hydrogenated butadiene-styrene block copolymer, a styrene-hydrogenated isoprene-styrene block copolymer, and a styrene-hydrogenated (isoprene/butadiene)-styrene block copolymer.

### Advantageous Effects of Invention

The present invention can provides a resin composition that can provide a prepreg, a resin sheet, a metal foil-clad laminate, and a printed wiring board with a low dielectric constant and dielectric loss tangent and excellent alkali resistance and desmear resistance; and a prepreg, a resin sheet, a metal foil-clad laminate, and a printed wiring board formed using this resin composition.

### Description of Embodiments

Hereinafter, the present invention will be described in detail using embodiments of the present invention (hereinafter, also referred to as "the present embodiment") as examples.

A resin composition according to the present embodiment contains a styrene-based elastomer (A), a styrene oligomer (B), a maleimide compound (C), and a cyanate ester compound (D), wherein the styrene-based elastomer (A) is at least one selected from the group consisting of a styrene-butadiene-styrene block copolymer, a styrene-isoprene-styrene block copolymer, a styrene-hydrogenated butadiene-styrene block copolymer, a styrene-hydrogenated isoprene-styrene block copolymer, and a styrene-hydrogenated (isoprene/butadiene)-styrene block copolymer.

The "styrene-based elastomer (A)" according to the present embodiment refers to an elastomer that is a block copolymer having a polystyrene block structure and may contain a random copolymer as appropriate. Preferably, the styrene-based elastomer (A) contains substantially no random copolymer. Here, "contains substantially no" means that the random copolymer or the random copolymerized region is not more than 10 mass% of the entire styrene-based elastomer. The random copolymer or the random copolymerized region is preferably not more than 5 mass%, more preferably not more than 1 mass%, and even more preferably 0 mass%.

The styrene-based elastomer (A) is at least one selected from a styrene-butadiene-styrene block copolymer, a styrene-isoprene-styrene block copolymer, a styrene-hydrogenated butadiene-styrene block copolymer, a styrene-hydrogenated isoprene-styrene block copolymer, and a styrene-hydrogenated (isoprene/butadiene)-styrene block copolymer. These copolymers (macromolecular polymers) may be used alone, or two or more may be used in combination. Among the copolymers, a styrene-hydrogenated butadiene-styrene block copolymer and a styrene-hydrogenated isoprene-styrene block copolymer are preferred in terms of low dielectric properties (low dielectric constant properties and low dielectric loss tangent properties).

Here, the styrene-based elastomer means an elastomer synthesized using styrene, but in the present embodiment, a styrene having a substituent may be used. Specifically, a styrene derivative, such as α-methylstyrene, 3-methylstyrene, 4-propylstyrene, or 4-cyclohexylstyrene, can be used.

The styrene-based elastomer (A) may have a reactive group at an end but preferably has no reactive group at an end.

Note that the styrene-based elastomer (A) is different from the styrene oligomer (B) described in detail later.

The content ratio of the styrene block (hereinafter, also referred to as "styrene ratio") in the styrene-based elastomer (A) is preferably from 15 to 70 mass% to balance miscibility with the styrene oligomer (B) and the low dielectric properties upon curing the resin composition. Here, the styrene ratio refers to the mass ratio of a styrene-based monomer (referring to styrene, and methylstyrene) among raw material monomers constituting the copolymer.

The number average molecular weight of the styrene-based elastomer (A) is preferably higher than 1600, more preferably not lower than 50000, and even more preferably not lower than 80000. The upper limit is preferably not higher than 300000, more preferably not higher than 200000, and even more preferably not higher than 150000.

In addition, the content of the styrene-based elastomer (A) in the resin composition according to the present embodiment is preferably not less than 1 part by mass and more preferably not less than 5 parts by mass relative to 100 parts by mass of resin solid component of the resin composition. Furthermore, the content is preferably not more than 30 parts by mass and more preferably not more than 15 parts by mass. The styrene-based elastomer (A) contained in such a range tends to improve low dielectric properties (low dielectric constant and low dielectric tangent properties) and chemical resistance. The resin composition may contain only one styrene-based elastomer (A) or may contain two or more styrene-based elastomers (A). The resin composition containing two or more styrene-based elastomers (A) preferably has a total amount of styrene-based elastomers (A) in the above range.

Here, "resin solid component of the resin composition" refer to components excluding an inorganic filler and a solvent from the resin composition. In addition, "100 parts by mass of resin solid component" means that a total amount of components excluding an inorganic filler and a solvent in the resin composition is 100 parts by mass.

The resin composition according to the present embodiment contains the styrene oligomer (B). The resin composition further contains the styrene oligomer (B) in addition to the styrene-based elastomer (A), and thus this can improve miscibility between the styrene-based elastomer (A), the maleimide compound (C), and the cyanate ester compound (D).

The styrene oligomer (B) has a number average molecular weight preferably from 178 to 1600 and more preferably from 200 to 1000.

In addition, the styrene oligomer (B) preferably has a styrene ratio of not lower than 90%. The styrene ratio in the styrene oligomer (B) refers to the mass ratio of a styrene-based monomer (referring to styrene, and methylstyrene) among raw material monomers constituting the oligomer.

The styrene oligomer (B) according to the present embodiment is preferably formed by polymerization of at least one compound selected from the group consisting of styrene, the styrene derivatives described above, and vinyltoluene, and is preferably a compound having a number average molecular weight from 178 to 1600, from 2 to 14 aromatic rings on average, and a boiling point of not lower than 300°C, and having no branched structure.

Examples of the styrene oligomer (B) used in the present embodiment include a styrene polymer, a vinyl toluene polymer, an α-methylstyrene polymer, a vinyltoluene-α-methylstyrene polymer, and a styrene-α-styrene polymer.

For the styrene polymer, a commercially available product may be used, and examples include Piccolastic A5 (available from Eastman Chemical), Piccolastic A-75 (available from Eastman Chemical), Piccotex 75 (available from Eastman Chemical), FTR-8100 (available from Mitsui Chemicals, Inc.), and FTR-8120 (available from Mitsui Chemicals, Inc.).

In addition, examples of the vinyl toluene-α-methylstyrene polymers include Piccotex LC (available from Eastman Chemical).

Furthermore, examples of the α-methylstyrene polymer include Crystalex 3070 (available from Eastman Chemical), Crystalex 3085 (available from Eastman Chemical), Crystalex (3100), Crystalex 5140 (available from Eastman Chemical), FMR-0100 (available from Mitsui Chemicals, Inc.), and FMR-0150 (available from Mitsui Chemicals, Inc.).

Moreover, examples of the styrene-α-styrene polymers include FTR-2120 (available from Mitsui Chemicals, Inc.).

In addition, the content of the styrene oligomer (B) in the resin composition according to the present embodiment is preferably not less than 1 part by mass and more preferably not less than 5 parts by mass relative to 100 parts by mass of resin solid component of the resin composition. Furthermore, the upper limit of the content is preferably not more than 30 parts by mass and more preferably not more than 25 parts by mass.

One of these styrene oligomers can be used alone, or two or more can be appropriately used in a mixture. In using two or more styrene oligomers, their total amount is preferably in the above range.

The maleimide compound (C) according to the present embodiment is any compound having one or more maleimide groups in one molecule. The use of the maleimide compound (C) tends to improve heat resistance and heat resistance upon moisture absorption.

Specific examples of the maleimide compound (C) include N-phenylmaleimide, N-hydroxyphenylmaleimide, bis(4-maleimidophenyl)methane, 2,2-bis{4-(4-maleimidophenoxy)-phenyl}propane, 4,4'-diphenylmethane bismaleimide, bis(3,5-dimethyl-4-maleimidophenyl)methane, bis(3,5-diethyl-4-maleimidophenyl)methane, phenylmethane maleimide, o-phenylene bismaleimide, m-phenylene bismaleimide, p-phenylene bismaleimide, o-phenylene biscitraconimide, m-phenylene biscitraconimide, p-phenylene biscitraconimide, 2,2-bis(4-(4-maleimidophenoxy)-phenyl)propane, 3,3'-dimethyl-5,5'-diethyl-4,4'-diphenylmethane bismaleimide, 4-methyl-1,3-phenylene bismaleimide, 1,6-bismaleimide-(2,2,4-trimethyl)hexane, 4,4'-diphenylether bismaleimide, 4,4'-diphenylsulfone bismaleimide, 1,3-bis(3-maleimidophenoxy)benzene, 1,3-bis(4-maleimidophenoxy)benzene, 4,4'-diphenylmethane biscitraconimide, 2,2-bis[4-(4-citraconimidophenoxy)phenyl]propane, bis(3,5-dimethyl-4-citraconimidophenyl)methane, bis(3-ethyl-5-methyl-4-citraconimidophenyl)methane, bis(3,5-diethyl-4-citraconimidophenyl)methane, maleimide compounds represented by Formula (2) below, maleimide compounds represented by Formula (3) below, and maleimide compounds represented by Formula (4) below, as well as prepolymers of these maleimide compounds or prepolymers of a maleimide compound and an amine compound.

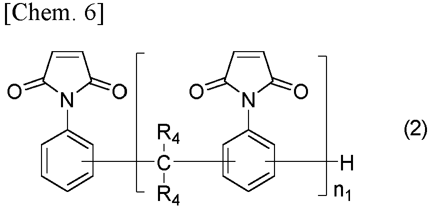

In Formula (2), R₄'s each independently represent a hydrogen atom or a methyl group and is preferably a hydrogen atom. In addition, in Formula (2), n₁ represents an integer of not less than 1, and the upper limit of n₁ is typically 10, and in terms of solubility in an organic solvent, n₁ is preferably 7. The maleimide compound (C) may contain compounds differing in n₁.

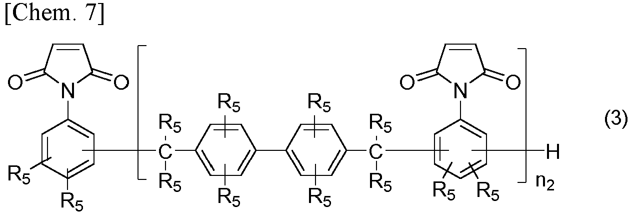

In Formula (3), a plurality of R₅'s each independently represents a hydrogen atom, an alkyl group having from 1 to 8 carbon atoms (e.g., such as a methyl group, an ethyl group, an n-propyl group, an isopropyl group, an n-butyl group, an isobutyl group, a t-butyl group, or an n-pentyl group), or a phenyl group. Among them, in terms of improving flame resistance and peel strength, the R₅ is preferably a group selected from the group consisting of a hydrogen atom, a methyl group, and a phenyl group, more preferably one of a hydrogen atom and a methyl group, and even more preferably a hydrogen atom.

In Formula (3), n₂ is an average value, and is 1 ≤ n₂ ≤ 10. In terms of even better solvent solubility, n₂ is preferably not more than 4, more preferably not more than 3, and even more preferably not more than 2. The maleimide compound (C) may contain compounds differing in n₂.

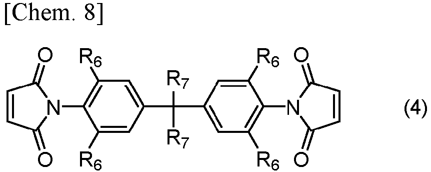

In Formula (4), R₆'s each independently represent a hydrogen atom, a methyl group, or an ethyl group; and R₇'s each independently represent a hydrogen atom or a methyl group. For the reason of providing an even better resin composition in terms of low dielectric constant properties and low dielectric loss tangent properties, R₆ is preferably a methyl group or an ethyl group.

For the maleimide compound (C) used in the present embodiment, a commercially available product may be used. Examples of the commercially available product of the maleimide compound represented by Formula (2) include "BMI-2300" available from Daiwa Kasei Industry Co., Ltd, examples of the commercially available product of the maleimide compound represented by Formula (3) include "MIR-3000" available from Nippon Kayaku Co., Ltd., examples of the commercially available product of the maleimide compound represented by Formula (4) include "BMI-70" available from Daiwa Kasei Industry Co., Ltd., and these maleimide compounds can be suitably used.

One of these maleimide compounds can be used alone, or two or more can be appropriately used in a mixture. Among them, the resin composition preferably contains at least one selected from the group consisting of the maleimide compound represented by Formula (2), the maleimide compound represented by Formula (3), and the maleimide compound represented by Formula (4), and more preferably contains at least the maleimide compound represented by Formula (2).

The content of the maleimide compound (C) in the resin composition according to the present embodiment is preferably not less than 5 parts by mass, more preferably not less than 10 parts by mass, and may be not less than 12 parts by mass relative to 100 parts by mass of resin solid component of the resin composition. The upper limit of the content is preferably not more than 50 parts by mass, more preferably not more than 45 parts by mass, even more preferably not more than 40 parts by mass, and also may be not more than 25 parts by mass or not more than 20 parts by mass.

One maleimide compound (C) can be used alone, or two or more can be appropriately used in a mixture. When two or more maleimide compounds (C) are used, their total amount is preferably in the above range.

The cyanate ester compound (D) according to the present embodiment is not particularly limited and is any resin having an aromatic moiety in the molecule, the aromatic moiety having at least one cyanate group (cyanate ester group). The cyanate ester compound (D) used in the present embodiment is preferably a non-liquid crystalline compound. The use of such a compound more remarkably provides the effects of the present invention described above.

Examples of the cyanate ester compound (D) include compounds represented by Formula (5).

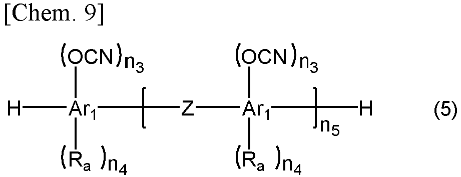

In Formula (5), each Ar₁ independently represents a phenylene group that may have a substituent, a naphthylene group that may have a substituent, or a biphenylene group that may have a substituent. Each Rₐ is independently selected from any one of a hydrogen atom, an alkyl group that has from 1 to 6 carbon atoms and may have a substituent, an aryl group that has from 6 to 12 carbon atoms and may have a substituent, an alkoxy group that has from 1 to 4 carbon atoms and may have a substituent, an aralkyl group in which an alkyl group having from 1 to 6 carbon atoms and an aryl group having from 6 to 12 carbon atoms are bonded and which may have a substituent, or an alkylaryl group in which an alkyl group having from 1 to 6 carbon atoms and an aryl group having from 6 to 12 carbon atoms are bonded and which may have a substituent. n₃ represents the number of the cyanato group bonded to Ar₁ and is an integer of 1 to 3. n₄ represents the number of Rₐ bonded to Ar₁ and is 4 - n₃ when Ar₁ is a phenylene group, 6 - n₃ when Ar₁ is a naphthylene group, and 8 - n₃ when Ar₁ is a biphenylene group. n₅ represents the average number of repetition and is an integer of from 0 to 50. The cyanate ester compound (D) may be a mixture of compounds differing in n₅. Each Z is independently selected from any one of a single bond, a divalent organic group having from 1 to 50 carbon atoms (a hydrogen atom may be substituted with a hetero atom), a divalent organic group having from 1 to 10 nitrogen atoms (such as -N-R-N-), a carbonyl group (-CO-), a carboxy group (-C(=O)O-), a carbonyl dioxide group (-OC(=O)O-), a sulfonyl group (-SO₂-), or a divalent sulfur atom or a divalent oxygen atom.

The alkyl group in Rₐ of Formula (5) may have either a chain structure (a linear structure or a branched structure) or a ring structure (such as a cycloalkyl group).

In addition, the hydrogen atom in the alkyl group and the aryl group in Rₐ in Formula (5) may be substituted with a halogen atom, such as a fluorine atom or a chlorine atom; an alkoxy group, such as a methoxy group or a phenoxy group; or a cyano group.

Specific examples of the alkyl group include a methyl group, an ethyl group, a propyl group, an isopropyl group, an n-butyl group, an isobutyl group, a tert-butyl group, an n-pentyl group, a 1-ethylpropyl group, a 2,2-dimethylpropyl group, a cyclopentyl group, a hexyl group, a cyclohexyl group, and a trifluoromethyl group.

Specific examples of the aryl group include a phenyl group, a xylyl group, a mesityl group, a naphthyl group, a phenoxyphenyl group, an ethylphenyl group, an o-, m-, or p-fluorophenyl group, a dichlorophenyl group, a dicyanophenyl group, a trifluorophenyl group, a methoxyphenyl group, and an o-, m-, or p-tolyl group.

Specific examples of the alkoxy group include a methoxy group, an ethoxy group, a propoxy group, an isopropoxy group, an n-butoxy group, an isobutoxy group, and a tert-butoxy group.

Specific examples of the divalent organic group in Z of Formula (5) include a methylene group, an ethylene group, a trimethylene group, a cyclopentylene group, a cyclohexylene group, a trimethylcyclohexylene group, a biphenylylmethylene group, a dimethylmethylene-phenylene-dimethylmethylene group, a fluorendiyl group, and a phthalidodiyl group. The hydrogen atom in the divalent organic group may be substituted with a halogen atom, such as a fluorine atom or a chlorine atom; an alkoxy group, such as a methoxy group or a phenoxy group; or a cyano group.

Examples of the divalent organic group having from 1 to 10 nitrogen atoms in Z of Formula (5) include an imino group and a polyimide group.

In addition, Examples of Z in Formula (5) include those with structures represented by Formula (6) below or Formula (7) below: 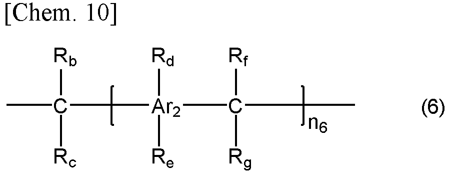 in Formula (6), Ar₂ is selected from any one of a phenylene group, a naphthylene group, and a biphenylene group; R_{b}, R_{c}, R_{f}, and R_{g} are each independently selected from any one of a hydrogen atom, an alkyl group having from 1 to 6 carbon atoms, an aryl group having from 6 to 12 carbon atoms, and an aryl group in which at least one of a trifluoromethyl group or a phenolic hydroxy group is substituted; R_{d} and Rₑ are each independently selected from any one of a hydrogen atom, an alkyl group having from 1 to 6 carbon atoms, an aryl group having from 6 to 12 carbon atoms, an alkoxy group having from 1 to 4 carbon atoms, and a hydroxy group; and n₆ represents an integer of from 0 to 5, but the cyanate ester compound (D) may be a mixture of compounds having groups represented by Formula (6) differing in n₆; 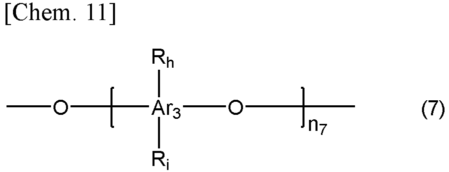 in Formula (7), Ar₃ is selected from any one of a phenylene group, a naphthylene group, or a biphenylene group; Rₕ and Rᵢ are each independently selected from any one of a hydrogen atom, an alkyl group having from 1 to 6 carbon atoms, an aryl group having from 6 to 12 carbon atoms, a benzyl group, an alkoxy group having from 1 to 4 carbon atoms, and an aryl group in which at least one of a hydroxy group, a trifluoromethyl group, or a cyanato group is substituted; and n₇ represents an integer of from 0 to 5, but the cyanate ester compound (D) may be a mixture of compounds having groups represented by Formula (7) differing in n₇.

Furthermore, examples of Z in Formula (5) include divalent groups represented by the formulas below. 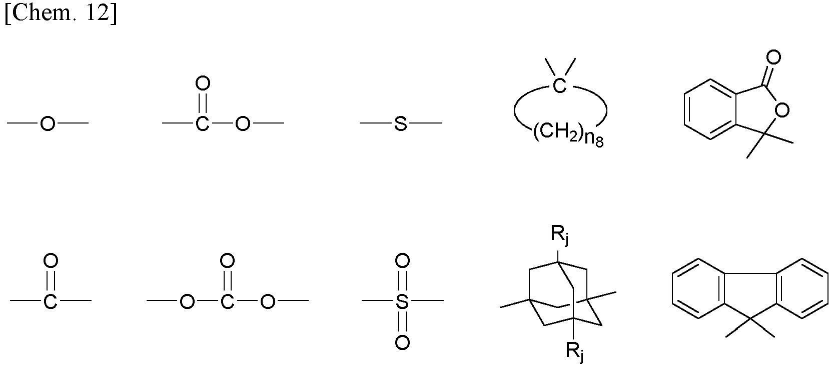 where n₈ represents an integer of 4 to 7; and Rⱼ's each independently represent a hydrogen atom or an alkyl group having from 1 to 6 carbon atoms.

Specific examples of Ar₂ of Formula (6) and Ar₃ of Formula (7) include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

The alkyl group and the aryl group in R_{b} to R_{g} of Formula (6) and Rₕ and Rᵢ of Formula (7) are similar to those described in Formula (5).

Examples of the cyanate ester compound represented by Formula (5) include a phenol novolac cyanate ester compound, a biphenyl aralkyl cyanate ester compound, a bisphenol A cyanate ester compound, a diallyl bisphenol A cyanate ester compound, a bisphenol E cyanate ester compound, a bisphenol F cyanate ester compound, a bisphenol M cyanate ester compound, a naphthol aralkyl cyanate ester compound, a naphthylene ether cyanate ester compound, a xylene resin cyanate ester compound, trisphenol methane cyanate, and an adamantane skeleton cyanate ester compound.

Specific examples of the cyanate ester compound represented by Formula (5) include, but not particularly limited to, cyanatobenzene, 1-cyanato-2-, 1-cyanato-3-, or 1-cyanto-4-methylbenzene, 1-cyanto-2-, 1-cyanato-3-, or 1-cyanto-4-methoxybenzene, 1-cyanato-2,3-, 1-cyanato-2,4-, 1-cyanato-2,5-, 1-cyanato-2,6-, 1-cyanato-3,4-, or 1-cyanto-3,5-dimethylbenzene, cyanatoethylbenzene, cyanatobutylbenzene, cyanatooctylbenzene, cyanatononylbenzene, 2-(4-cyanaphenyl)-2-phenylpropane (a cyanate of 4-α-cumylphenol), 1-cyanato-4-cyclohexylbenzene, 1-cyanato-4-vinylbenzene, 1-cyanato-2- or 1-cyanto-3-chlorobenzene, 1-cyanto-2,6-dichlorobenzene, 1-cyanato-2-methyl-3-chlorobenzene, cyanatonitrobenzene, 1-cyanto-4-nitro-2-ethylbenzene, 1-cyanato-2-methoxy-4-allylbenzene (a cyanate of eugenol), methyl(4-cyanatophenyl)sulfide, 1-cyanato-3-trifluoromethylbenzene, 4-cyanatobiphenyl, 1-cyanato-2- or 1-cyanto-4-acetylbenzene, 4-cyanatobenzaldehyde, methyl 4-cyanatobenzoate ester, phenyl 4-cyanatobenzoate ester, 1-cyanato-4-acetoaminobenzene, 4-cyanatobenzophenone, 1-cyanto-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-dimethylbenzene, 1,3-dicyanato-2,4,6-trimethylbenzene, 1,3-dicyanato-5-methylbenzene, 1-cyanato or 2-cyanatonaphthalene, 1-cyanato 4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6-, or 2,7-dicyanatosinaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis (3-allyl-4-cyanatophenyl)propane, 2,2-bis(4-cyanato-3-methylphenyl)propane, 2,2-bis(2-cyanato-5-biphenylyl)propane, 2,2-bis (4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propene-1-one, bis(4-cyanatophenyl)ether, bis(4-cyanatophenyl)sulfide, bis(4-cyanatophenyl)sulfone, 4-cyanatobenzoic acid-4-cyanatophenyl ester (4-cyanatophenyl-4-cyanatobenzoate), bis-(4-cyanatophenyl)carbonate, 1,3-bis(4-cyanatophenyl)adamantane, 1,3-bis(4-cyanatophenyl)-5,7-dimethyladamantane, 3,3-bis(4-cyanatophenyl)isobenzofuran-1(3H)-one (a cyanate of phenolphthalein), 3,3-bis(4-cyanato-3-methylphenyl)isobenzofuran-1(3H)-one (a cyanate of o-cresolphthalein), 9,9-bis(4-cyanatophenyl)fluorene, 9,9-bis(4-cyanatoto-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis (N-methyl-4-cyanatoanilino)-6-(N-methylanilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimide, tris(3,5-dimethyl-4-cianatobenzyl)isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one; and compounds obtained by cyanate esterification of a phenolic resin, such as a phenol novolac resin and a cresol novolac resin (a resin obtained by reacting phenol, an alkyl-substituted phenol, or a halogen-substituted phenol with a formaldehyde compound, such as formalin or paraformaldehyde, in an acidic solution according to a well-known method), a trisphenol novolac resin (a resin obtained by reacting hydroxybenzaldehyde with phenol in the presence of an acid catalyst), a fluorene novolac resin (a resin obtained by reacting a fluorenone compound with a 9,9-bis(hydroxyaryl)fluorene in the presence of an acid catalyst), a phenol aralkyl resin, a cresol aralkyl resin, a naphthol aralkyl resin, and a biphenyl aralkyl resin (a resin obtained by reacting a bishalogenomethyl compound, such as a compound represented by Ar₄-(CH₂Z')₂, with a phenolic compound by an acid catalyst or without catalyst according to a well-known method; a resin obtained by reacting a bis(alkoxymethyl) compound, such as a compound represented by Ar₄-(CH₂OR)₂, or a bis(hydroxymethyl) compound, such as a compound represented by Ar₄-(CH₂OH)₂, with a phenolic compound in the presence of an acid catalyst according to a well-known method; or a resin obtained by polycondensation of an aromatic aldehyde compound, an aralkyl compound, and a phenolic compound according to a well-known method), a phenol-modified xylene formaldehyde resin (a resin obtained by reacting a xylene formaldehyde resin with a phenolic compound in the presence of an acid catalyst according to a well-known method), a modified naphthalene formaldehyde resin (a resin obtained by reacting a naphthalene formaldehyde resin with a hydroxy-substituted aromatic compound in the presence of an acid catalyst according to a well-known method), a phenol-modified dicyclopentadiene resin, and a phenolic resin having a polynaphthylene ether structure (a resin obtained by dehydration condensation of a polyvalent hydroxynaphthalene compound having two or more phenolic hydroxy groups in one molecule in the presence of a basic catalyst according to a well-known method), according to a similar method described above. One of these cyanate ester compounds can be used alone, or two or more can be used in a mixture.

Among these cyanate ester compounds, phenol novolac cyanate ester compounds, naphthol aralkyl cyanate ester compounds, naphthylene ether cyanate ester compounds, bisphenol A cyanate ester compounds, and diallyl bisphenol cyanate ester are preferred, and naphthol aralkyl cyanate ester compounds are particularly preferred.

A cured product of the resin composition produced using these cyanate ester compounds has excellent properties, such as heat resistance and low dielectric properties (low dielectric constant properties and low dielectric loss tangent properties).

In addition, the content of the cyanate ester compound (D) in the resin composition according to the present embodiment is preferably not less than 5 parts by mass, more preferably not less than 15 parts by mass, even more preferably not less than 25 parts by mass, and still more preferably not less than 30 parts by mass relative to 100 parts by mass of resin solid component of the resin composition. Furthermore, the upper limit of the content is preferably not more than 70 parts by mass, more preferably not more than 60 parts by mass, and may be not more than 50 parts by mass.

One of these cyanate ester compounds (D) can be used alone, or two or more can be appropriately used in a mixture. When two or more cyanate ester compounds (D) are used, their total amount is preferably in the above range.

The resin composition according to the present embodiment can suitably contain a polyphenylene ether (E). The polyphenylene ether (E) is preferably a compound containing a polymer of a structural unit represented by Formula (8): 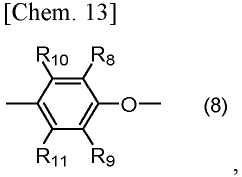 in Formula (8), R₈, R₉, R₁₀, and R₁₁ each independently represent an alkyl group having 6 or less carbon atoms, an aryl group, a halogen atom, or a hydrogen atom.

The polymer may further contain a structure represented by Formula (9): 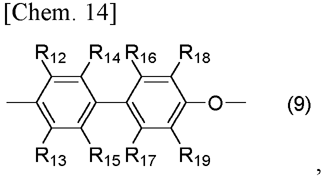
in Formula (9), R₁₂, R₁₃, R₁₄, R₁₈, and R₁₉ each independently represent an alkyl group having 6 or less carbon atoms or a phenyl group; and R₁₅, R₁₆, and R₁₇ each independently represent a hydrogen atom, an alkyl group having 6 or less carbon atoms, or a phenyl group; and
a structure represented by Formula (10): 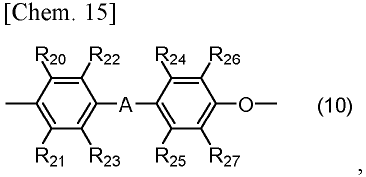
in Formula (10), R₂₀, R₂₁, R₂₂, R₂₃, R₂₄, R₂₅, R₂₆, and R₂₇ each independently represent a hydrogen atom, an alkyl group having 6 or less carbon atoms, or a phenyl group; and -A- is a linear, branched, or cyclic divalent hydrocarbon group having 20 or less carbon atoms.

For the polyphenylene ether (E), a modified polyphenylene ether can be used, in which some or all of the ends are functionalized with an ethylenically unsaturated group, such as a vinylbenzyl group; an epoxy group; an amino group; a hydroxy group; a mercapto group; a carboxy group; a methacryl group; and a silyl group. One of these modified polyphenylene ether compounds may be used alone, or two or more may be used in combination.

Examples of the hydroxy group-terminated modified polyphenylene ether include SA90 available from SABIC Innovative Plastics IP BV. Examples of the methacrylic group-terminated polyphenylene ether include SA9000 available from SABIC Innovative Plastics IP BV.

The method for producing the modified polyphenylene ether is any method that can provide the effects of the present invention. For example, the modified polyphenylene ether can be produced by the method described in JP 4591665 B.

The modified polyphenylene ether is preferably a modified polyphenylene ether having an ethylenically unsaturated group at an end. Examples of the ethylenically unsaturated group include alkenyl groups, such as an ethenyl group, an allyl group, an acryl group, a methacryl group, a propenyl group, a butenyl group, a hexenyl group, and octenyl group; cycloalkenyl groups, such as a cyclopentenyl group and a cyclohexenyl group; and alkenylaryl groups, such as a vinylbenzyl group and a vinylnaphthyl group; and a vinylbenzyl group is preferred. The modified polyphenylene ether may have a single or a plurality of terminal ethylenically unsaturated groups, and the terminal ethylenically unsaturated groups may be identical or different functional groups.

Examples of the modified polyphenylene ether having an ethylenically unsaturated group at an end include compounds represented by Formula (1): 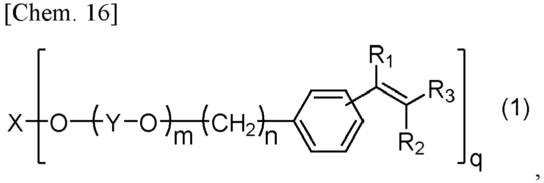 in Formula (1), X represents an aryl group (aromatic group); -(Y-O)ₘ- represents a polyphenylene ether moiety; R₁, R₂, and R₃ each independently represent a hydrogen atom, an alkyl group, an alkenyl group, or an alkynyl group; m represents an integer of from 1 to 100; n represents an integer of from 1 to 6; q represents an integer of 1 to 4; n is preferably an integer of not less than 1 and not more than 4, more preferably 1 or 2, and ideally 1; and q is preferably an integer of not less than 1 and not more than 3, more preferably 1 or 2, and ideally 2.

Examples of the aryl group represented by X in Formula (1) include a group obtained by removing q hydrogen atom or hydrogen atoms from one ring structure selected from a benzene ring structure, a biphenyl structure, an indenyl ring structure, and a naphthalene ring structure (e.g., a phenyl group, a biphenyl group, an indenyl group, and a naphthyl group), and a biphenyl group is preferred.

Here, the aryl group represented by X may include a diphenyl ether group in which the above aryl groups are bonded with an oxygen atom, a benzophenone group in which the above aryl groups are bonded with a carbonyl group, and a 2,2-diphenylpropane group in which the above aryl groups are bonded with an alkylene group.

In addition, the aryl group may be substituted with a common substituent, such as an alkyl group (suitably an alkyl group having from 1 to 6 carbon atoms and particularly a methyl group), an alkenyl group, an alkynyl group, or a halogen atom. However, the "aryl group" is substituted with a polyphenylene ether moiety via an oxygen atom, the limit of the number of the common substituent depends on the number of the polyphenylene ether moiety.

For the polyphenylene ether moiety in Formula (1), a structural unit represented by Formula (8), (9), or (10) can be used, and a structural unit represented by Formula (8) is particularly preferably contained.

In addition, the modified polyphenylene ether represented by Formula (1) preferably has a number average molecular weight of not lower than 1000 and not higher than 7000. Furthermore, in Formula (1), a compound with a minimum melt viscosity of not more than 50000 Pa•s can be used. In particular, in Formula (1), the compound with a number average molecular weight of not less than 1000 and not more than 7000 and a minimum melt viscosity of not more than 50000 Pa•s is preferred.

The number average molecular weight is measured using gel permeation chromatography according to the common method. The number average molecular weight is more preferably from 1000 to 3000. With the number average molecular weight of the modified polyphenylene ether of not lower than 1000 and not higher than 7000, the resin composition more effectively exhibits the effect of achieving both moldability and electrical properties.

The minimum melt viscosity is measured using a dynamic viscoelasticity measuring device according to the common method. The minimum melt viscosity is more preferably from 500 to 50000 Pa•s. With the minimum melt viscosity of not more than 50000 Pa•s, the resin composition according to the present embodiment more effectively exhibits the effect of achieving both moldability and electrical properties.

Among the compounds represented by Formula (1), the modified polyphenylene ether is preferably Formula (11) below: 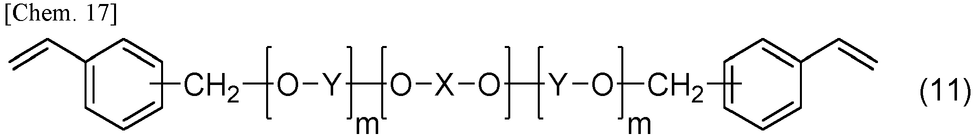 in Formula (11), X is an aryl group (aromatic group); each -(Y-O)ₘ- independently represents a polyphenylene ether moiety; and each m independently represents an integer of from 1 to 100.
-(Y-O)ₘ- and m are synonymous with those in Formula (1).

X in Formula (1) and Formula (11) is preferably Formula (12), Formula (13), or Formula (14), and -(Y-O)ₘ- in Formula (1) and Formula (11) are preferably a structure in which Formula (15) or Formula (16) is arranged or a structure in which Formula (15) and Formula (16) are randomly arranged. 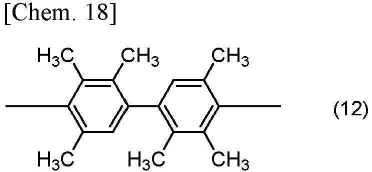 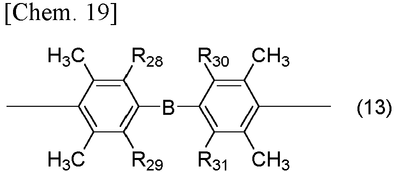 in Formula (13), R₂₈, R₂₉, R₃₀, and R₃₁ each independently represent a hydrogen atom or a methyl group; and -B- is a linear, branched, or cyclic divalent hydrocarbon group having 20 or less carbon atoms. 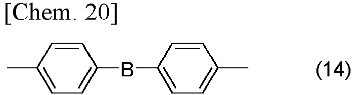 in Formula (14), -B- is a linear, branched, or cyclic divalent hydrocarbon group having 20 or less carbon atoms.

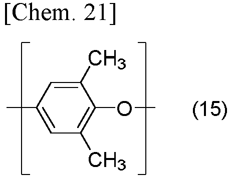

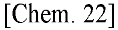

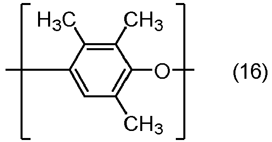

The method for producing the modified polyphenylene ether having a structure represented by Formula (11) is not particularly limited, and the modified polyphenylene ether can be produced, for example, by vinylbenzyl etherification of a terminal phenolic hydroxy group of a bifunctional phenylene ether oligomer obtained by oxidative coupling of a bifunctional phenolic compound and a monofunctional phenolic compound.

In addition, a commercially available product of such a modified polyphenylene ether can be used, and, for example, OPE-2St 1200 and OPE-2st 2200 available from Mitsubishi Gas Chemical Company, Inc. can be suitably used.

Furthermore, the content of the polyphenylene ether (E) in the resin composition according to the present embodiment is preferably not less than 5 parts by mass, more preferably not less than 15 parts by mass, and even more preferably not less than 18 parts by mass relative to 100 parts by mass of resin solid component of the resin composition. In addition, the upper limit of the content is preferably not more than 40 parts by mass, more preferably not more than 30 parts by mass, and may be not more than 25 parts by mass.

One of these polyphenylene ethers (E) can be used alone, or two or more can be appropriately used in a mixture. When two or more polyphenylene ethers (E) are used, their total amount is preferably in the above range.

The resin composition according to the present embodiment can suitably contain an inorganic filler (F). The type of the inorganic filler (F) is any of those commonly used in insulating resins for printed wiring boards or laminates, but examples include silicas, such as natural silicas, fused silicas, synthetic silicas, amorphous silicas, and hollow silicas; alumina, zinc oxide, magnesium oxide, zirconium oxide, aluminum hydroxide, boehmite, boron nitride, aggregated boron nitride, silicon nitride, aluminum nitride; molybdenum compounds, such as molybdenum oxide and zinc molybdate; zinc borate, aluminum nitride, barium sulfate; metal hydrates, such as a heat-treated aluminum hydroxide product (a product obtained by heating aluminum hydroxide to partially reduce the crystalline water) and magnesium hydroxide; zinc stannate, clay, kaolin, talc, calcined clay, calcined kaolin, calcined talc, natural mica, synthetic mica; E-glass, A-glass, NE-glass, C-glass, L-glass, D-glass, S-glass, M-glass G20, glass short fibers (including glass fine powders of E-glass, T-glass, D-glass, S-glass, and Q-glass), hollow glass, and spherical glass. Among these inorganic fillers, silicas, such as natural silicas, fused silicas, synthetic silicas, amorphous silicas, and hollow silicas, are preferred in terms of dielectric properties. One of these inorganic fillers can be used alone, or two or more can be appropriately used in combination.

The average particle diameter (D50) of the inorganic filler (F) is preferably from 0.1 to 3 µm and more preferably from 0.2 to 2 µm. The inorganic filler (F) with an average particle diameter (D50) within the above range has further improved dispersibility in the resin composition. This further improves the flow characteristics during molding and is more likely to prevent breakage when using a small diameter drill bit. Here, "the average particle diameter (D50)" means a particle diameter when 50% of the total volume is reached when measuring the particle size distribution of a powder introduced into a water dispersion medium with a laser diffraction particle size distribution meter and integrating the volume from small particles.

The content of the inorganic filler (F) in the resin composition according to the present embodiment is preferably not less than 50 parts by mass, preferably not less than 75 parts by mass, and may be not less than 100 parts by mass relative to 100 parts by mass of resin solid component of the resin composition in terms of electrical properties. In addition, the upper limit of the content is preferably not more than 1600 parts by mass, preferably not more than 500 parts by mass, and more preferably not more than 200 parts by mass.

In the resin composition according to the present embodiment, a silane coupling agent or a wet dispersant can be used in combination with the inorganic filler (F) to improve dispersibility of the inorganic filler and adhesion strength of the resin with the inorganic filler or a glass cloth. These silane coupling agents are not particularly limited and are any silane coupling agents commonly used for surface treatment of inorganic materials. Specific examples include epoxysilane-based coupling agents, such as γ-glycidoxypropyltrimethoxysilane; aminosilane-based coupling agents, such as γ-aminopropyltriethoxysilane and N-β-(aminoethyl)-γ-aminopropyltrimethoxysilane; epoxysilane-based coupling agents, such as γ-glycidoxypropyltrimethoxysilane; vinyl silane-based coupling agents, such as γ-methacryloxypropyltrimethoxysilane; cationic silane-based coupling agents, such as N-β-(N-vinylbenzylaminoethyl)-γ-aminopropyltrimethoxysilane hydrochloride; and phenylsilane-based coupling agents. One of these silane coupling agents can be used alone, or two or more can be appropriately used in combination. In addition, the wet dispersant is any dispersion stabilizer used for paints. Examples include wet dispersants, such as Disperbyk-110, 111, 180, 161, 2009, 2152, BYK-W996, W9010, and W903 available from BYK Japan KK.

For the resin composition according to the present embodiment, a macromolecular compound of various types, such as an additional thermosetting resin, an additional thermoplastic resin and its oligomer, or an elastomer; an additional flame retardant compound; or an additive of various types can be also used in combination. These compounds or additives are any of those commonly used. Examples of the flame retardant compound include phosphate esters, melamine phosphate, phosphorus-containing epoxy resins; nitrogen compounds, such as melamine and benzoguanamine; oxazine ring-containing compounds; and silicone-based compounds. Examples of the additive include ultraviolet absorbers, antioxidants, photopolymerization initiators, fluorescent brightening agents, photosensitizers, dyes, pigments, thickeners, lubricants, antifoaming agents, dispersants, leveling agents, and brighteners, which can be appropriately used in combination as desired.

In the resin composition according to the present embodiment, a total of the styrene-based elastomer (A), the styrene oligomer (B), the maleimide compound (C), the cyanate ester compound, and (D) the polyphenylene ether (E) preferably accounts for not less than 90 mass%, more preferably accounts for not less than 95 mass%, and even more preferably accounts for not less than 97 mass% of resin solid component.

For the resin composition according to the present embodiment, a curing accelerator can be also used in combination to adjust the curing rate appropriately. Examples of such a compound include organic peroxides exemplified by benzoyl peroxide, lauroyl peroxide, acetyl peroxide, para-chlorobenzoyl peroxide, and di-tert-butyl-di-perphthalate; azo compounds, such as azobisnitrile; tertiary amines, such as N,N-dimethylbenzylamine, N,N-dimethylaniline, N,N-dimethyltoluidine, 2-N-ethylanilinoethanol, tri-n-butylamine, pyridine, quinoline, N-methylmorpholine, triethanolamine, triethylenediamine, tetramethylbutanediamine, and N-methylpiperidine; imidazoles, such as 2-ethyl-4-methylimidazole, 2-phenyl-4-methylimidazole, and triphenylimidazole; monomeric phenols, such as phenol, xylenol, cresol, resorcin, and catechol; organometallic salts, such as lead naphthenate, lead stearate, zinc naphthenate, zinc octylate, manganese octylate, tin oleate, dibutyl tin maleate, manganese naphthenate, cobalt naphthenate, and iron acetylacetonate; those formed by dissolving the above organometallic salt in a monomeric hydroxy group-containing compound such as phenol and bisphenol; inorganic metal salts, such as tin chloride, zinc chloride, and aluminum chloride; and organic tin compounds, such as dioctyl tin oxide, other tin alkyls, and alkyl tin oxides.

Furthermore, the resin composition according to the present embodiment may contain an organic solvent as necessary. The use of an organic solvent, for example, reduce viscosity during preparation of the resin composition, thus improving handling properties as well as increasing impregnation to a substrate, such as a glass cloth. The type of the solvent is any of those that can partially or entirely dissolve the mixture of the styrene-based elastomer (A), the styrene oligomer (B), the maleimide compound (C), and the cyanate ester compound (D). Specific examples of the solvent include, but not particularly limited to, ketones, such as acetone, methyl ethyl ketone, and methyl cellosolve; aromatic hydrocarbons, such as toluene and xylene; amides, such as dimethylformamide; and propylene glycol methyl ether and its acetate. One of these solvents can be used alone, or two or more can be used in combination

The resin composition according to the present embodiment can be prepared according to a common method, and the method for preparing the resin composition is any method providing a resin composition uniformly containing the styrene-based elastomer (A), the styrene oligomer (B), the maleimide compound (C), the cyanate ester compound (D), and the additional optional component described above. For example, the resin composition according to the present embodiment can be easily prepared by sequentially blending the styrene-based elastomer (A), the styrene oligomer (B), the maleimide compound (C), and the cyanate ester compound (D) in a solvent and thoroughly stirring.

When preparing the resin composition according to the present embodiment, an organic solvent can be used as necessary. The type of the solvent is any of those that can partially or entirely dissolve the mixture of the styrene-based elastomer (A), the styrene oligomer (B), the maleimide compound (C), and the cyanate ester compound (D). Specific examples of the solvent are as described above.

In addition, when preparing the resin composition, a well-known process (such as stirring, mixing, or kneading process) can be performed to dissolve or disperse each component uniformly. For example, for uniformly dispersing the inorganic filler (F), stirring and dispersing processes using a stirring tank equipped with a stirrer having appropriate stirring capability increases dispersibility to the resin composition. The above stirring, mixing, or kneading process can be performed appropriately using a well-known device, such as a device for mixing, such as, for example, a ball mill or a bead mill; or a revolution/rotation mixer.

On the other hand, a prepreg according to the present embodiment is formed by combining the resin composition described above with a substrate. That is, the prepreg according to the present embodiment has a substrate and a layer formed from the resin composition described above. The prepreg according to the present embodiment can be obtained by impregnating or coating the resin composition according to the present embodiment described above to a substrate. The method for producing the prepreg can be performed according to a common method and is not particularly limited. For example, the prepreg according to the present embodiment can be produced by such a method of impregnating or coating the resin composition according to the present embodiment to a substrate and then drying in a dryer at 100 to 200°C for 1 to 30 minutes to semi-cure (to B-stage) the resin composition. The prepreg according to the present embodiment is not particularly limited, but the amount of the resin composition (including the inorganic filler (F)) relative to the total amount of the prepreg is preferably in a range from 30 to 90 mass%.

The substrate used in the prepreg according to the present embodiment is not particularly limited, and a well-known substrate used in various printed wiring board materials can be used by appropriate selection according to the intended use or performance. Specific examples of the substrate include, but not particularly limited to, glass fibers, such as those of E-glass, D-glass, S-glass, Q-glass, spherical glass, NE-glass, L-glass, and T-glass; inorganic fibers other than those of glass, such as those of quartz; and organic fibers, such as those of wholly aromatic polyamide including polyparaphenylene terephthalamide (Kevlar (trade name) available from Du Pont Co., Ltd.) and copolyparaphenylene•3,4'oxydiphenylene•terephthalamide (Technola (trade name) available from Teijin Techno Products Ltd.), polyester including 2,6-hydroxynaphthoic acid•parahydroxy benzoic acid (Vectran (trade name) available from Kuraray Co., Ltd.) and Zxion (trade name, available from KB Seiren Ltd.), polyparaphenylene benzoxazole (Zylon (trade name) available from Toyobo Co., Ltd.), and polyimide.

One of these substrates can be used alone, or two or more can be used in combination. Examples of the known form of the substrate include woven fabrics, nonwoven fabrics, rovings, chopped strand mats, and surfacing mats, and examples of the known weave of woven fabrics include plain weave, mat weave, and twill weave. The form or weave can be appropriately selected for use from these well-known forms or weave according to the intended use or performance. Those obtained by subjecting the selected substrate to fiber opening or a glass woven fabric treated with a silane coupling agent are suitably used. The thickness and mass of the substrate are not particularly limited, but typically, a substrate with a thickness of approximately 0.01 to 0.3 mm is preferably used. In particular, in terms of strength and water absorbability, the substrate is more preferably a glass woven fabric with a thickness of not more than 200 µm and a mass of not more than 250 g/m² and more preferably a low dielectric glass cloth made of glass fibers, such as L-glass, NE-glass, or Q-glass, exhibiting low dielectric constant properties and low dielectric loss tangent properties.

A metal foil-clad laminate according to the present embodiment has one or more laminated prepregs described above, and a metal foil disposed on one side or both sides of the laminated prepregs. The method for producing the metal foil-clad laminate can be performed according to a common method and is not particularly limited. For example, the metal foil-clad laminate can be obtained by layering one or more prepregs described above and disposing a metal foil on one side or both sides of the layered prepregs. More specifically, the metal foil-clad laminate can be produced by layering one or a plurality of the prepregs described above, configuring a metal foil, such as a copper or aluminum foil, to be disposed on one side or both sides of the layered prepregs as desired, and laminate-molding the layered prepregs and the disposed metal foil as necessary.

The metal foil used here is any metal foil used in printed wiring board materials but is preferably a copper foil, such as a rolled copper foil and an electrolytic copper foil. In addition, the thickness of the metal foil is not particularly limited but is preferably from 1.5 to 70 µm and more preferably from 2 to 35 µm. The method for molding the metal foil-clad laminate and the molding conditions are not particularly limited, and common techniques and conditions for laminates for printed wiring boards and multilayer boards can be applied. For example, for molding the metal foil-clad laminate, a multi-stage press, a multi-stage vacuum press, a continuous molding machine, an autoclave molding machine, can be used, and typically a temperature is from 100 to 300°C, a pressure is from 2 to 100 kgf/cm², and a heating time is from 0.05 to 5 hours. Furthermore, post-curing can be also performed at a temperature of 150 to 300°C as necessary. In addition, also a multilayer board can be formed by laminate-molding the prepreg according to the present embodiment and a separately produced wiring board for an inner layer in combination.

The metal foil-clad laminate according to the present embodiment can be suitably used as a printed wiring board by forming a predetermined wiring pattern. In addition, the metal foil-clad laminate of the present invention has low thermal expansion coefficient, lead free solder properties, and good low dielectric properties and can be used particularly effectively as a printed wiring board for high frequency and high multilayer requiring such performance.

A printed wiring board according to the present embodiment has an insulating layer and a conducting layer formed on a surface of the insulating layer, in which the insulating layer includes a layer formed from the resin composition according to the present embodiment. Such a printed wiring board can be produced, for example, by the following method. First, the metal foil-clad laminate, such as the copper-clad laminate, according to the present embodiment is prepared. The surface of the metal foil-clad laminate is subjected to etching treatment to form an inner layer circuit and to produce an inner layer substrate. The inner layer circuit surface of the inner layer substrate is subjected to surface treatment to increase the adhesion strength as necessary, then the required number of the prepregs of the present invention are layered on the inner layer circuit surface, a metal foil for an outer layer circuit is further laminated on the outer side, and the laminate is heated and pressurized to integrally mold. A multilayer laminate is thus produced, the multilayer laminate in which an insulating layer formed from the substrate and a cured product of the thermosetting resin composition is formed between the inner layer circuit and the metal foil for the outer layer circuit. Then, this multilayer laminate board is subjected to hole formation for a through hole or a via hole, and then desmear process is performed to remove smear, which is a residue of a resin derived from a resin component contained in the cured product layer. Then, a plated metal film for conducting the inner layer circuit and the metal foil for the outer layer circuit is formed on the wall surface of the hole, further the metal foil for the outer layer circuit is subjected to etching treatment to form the outer layer circuit, and the printed wiring board is produced.

This printed wiring board is configured to have an insulating layer and a conducting layer formed on a surface of the insulating layer, in which the insulating layer contains at least any of the resin composition according to the present embodiment described above or its cured product. That is, the prepreg according to the present embodiment (including the substrate and at least any of the resin composition according to the present embodiment impregnated to the substrate or a cured product of the resin composition) or the prepreg layer of the metal foil-clad laminate (the layer containing at least any of the resin composition according to the present embodiment or its cured product) is to constitute the insulating layer containing at least any of the resin composition according to the present embodiment or its cured product.

A resin sheet according to the present embodiment includes a layer formed from the resin composition according to the present embodiment. The resin sheet according to the present embodiment may be a laminated resin sheet laminated on a support or may be a monolayer resin sheet including no support.

The laminated resin sheet has a support and a layer disposed on a surface of the support, the layer being formed from the resin composition according to the present embodiment. This laminated resin sheet can be produced according to a common method, and the production method is not particularly limited. For example, the laminated resin sheet can be obtained by coating a solution in which the resin composition according to the present embodiment is dissolved in a solvent to the support and drying the solution.

The support used here is not particularly limited. Examples of the support include, but not limited to, polyethylene films, polypropylene films, polycarbonate films, polyethylene terephthalate films, ethylene tetrafluoroethylene copolymer films, and release films in which a release agent is coated to a surface of the film above; organic-based film substrates, such as polyimide films; conductive foils, such as copper foils and aluminum foils; plate-like supports, such as glass plates, SUS plates, and FRP plates.

Examples of the coating method include a method of coating a solution in which the resin composition according to the present embodiment is dissolved in a solvent onto the support using a bar coater, a die coater, a doctor blade, or a Baker applicator.

In addition, the monolayer resin sheet is formed by molding the resin composition according to the present embodiment into a sheet shape. The method for producing a monolayer resin sheet can be performed according to a common method and is not particularly limited. Examples include a method of coating a solution in which the resin composition according to the present embodiment is dissolved in a solvent to a support and drying the solution, and then removing the support from the laminated resin sheet by peeling or etching in the above method for producing the laminated resin sheet. Furthermore, a monolayer sheet (resin sheet) can also be obtained without using a support, for example, by feeding a solution in which the resin composition according to the present embodiment described above is dissolved in a solvent into a mold having a sheet-shaped cavity and drying to mold the solution into a sheet shape.

When producing the monolayer resin sheet or laminated resin sheet according to the present embodiment, the drying conditions for removing the solvent are not particularly limited, but the solvent would be apt to remain in the resin composition at low temperature, and the curing of the resin composition would proceed at high temperature, and thus the drying conditions are preferably at a temperature of 20°C to 170°C for 1 to 90 minutes.

In addition, the thickness of the resin layer in the monolayer resin sheet or laminated resin sheet according to the present embodiment can be adjusted by the concentration of the solution of the resin composition according to the present embodiment and the coating thickness and is not particularly limited. However, typically, the thicker the coating, the more likely the solvent will remain during drying, and thus the thickness is preferably from 0.1 to 500 µm.

### Examples

Hereinafter, the present embodiment will be specifically described using a synthesis example, examples, and comparative examples, but the present invention is not limited to these examples.

### Synthesis Example 1: Synthesis of naphthol aralkyl cyanate ester compound (SNCN)

First, 300 g (1.28 mol in terms of an OH group) of a 1-naphthol aralkyl resin (available from Nippon Steel & Sumikin Materials Co., Ltd.) and 194.6 g (1.92 mol) of triethylamine (1.5 mol relative to 1 mol of hydroxy groups) were dissolved in 1800 g of dichloromethane, and this solution was designated as a solution 1.

Under stirring and maintaining 125.9 g (2.05 mol) of cyanogen chloride (1.6 mol relative to 1 mol of hydroxy groups), 293.8 g of dichloromethane, 194.5 g of a 36% hydrochloric acid (1.92 mol) (1.5 mol relative to 1 mol of hydroxy groups), and 1205.9 g of water at a liquid temperature of -2 to -0.5°C, the solution 1 was poured thereinto over 30 minutes. After the completion of pouring the solution 1, the mixture was stirred at the same temperature for 30 minutes, and then a solution (solution 2) in which 65 g (0.64 mol) of triethylamine (0.5 mol relative to 1 mol of hydroxy groups) was dissolved in 65 g of dichloromethane was poured over 10 minutes. After the completion of pouring the solution 2, the reaction was completed by stirring at the same temperature for 30 minutes.

The reaction liquid was allowed to stand, and the organic phase and the aqueous phase were separated. The resulting organic phase was washed 5 times with 1300 g of water. The electrical conductivity of the drainage water from the fifth water washing was 5 µS/cm, confirming that a removable ionic compound was sufficiently removed by washing with water.

The organic phase after water washing was concentrated under reduced pressure, finally concentrated to dryness at 90°C for 1 hour, and 331 g of the target naphthol aralkyl cyanate ester compound (SNCN) (an orange viscous material) was obtained. The mass average molecular weight Mw of the resulting SNCN was 600. In addition, the IR spectrum of the SNCN showed an absorption at 2250 cm⁻¹ (a cyanate ester group) and no absorption of a hydroxy group.

### Example 1

A varnish was obtained by mixing 10 parts by mass of a styrene-butadiene-styrene block copolymer (TR2630 available from JSR Corporation, styrene ratio of 32%, having no reactive group at an end), 10 parts by mass of an α-methylstyrene polymer (Crystalex 3085 available from Eastman Chemical, number average molecular weight: 664), 24 parts by mass of a maleimide compound (BMI-2300 available from Daiwa Kasei Industry Co., Ltd.), 56 parts by mass of a cyanate ester compound (SNCN) obtained from Synthesis Example 1, and 150 parts by mass of a spherical silica (SC2050-MB available from Admatechs Company Limited, average particle diameter of 0.5 µm), and diluting the solids with methyl ethyl ketone to 65 mass%.

The resulting varnish was impregnated to a low dielectric glass cloth with a thickness of 0.069 mm, the glass cloth was heat-dried at 165°C for 5 minutes using a dryer (pressure-resistant explosion-proof steam dryer available from Takasugi Mfg. Co. Ltd.), and a prepreg with a resin composition content of 60 mass% was obtained. For two or eight prepregs layered, a 12-µm copper foil (3EC-M3-VLP available from Mitsui Mining & Smelting Co., Ltd.) was disposed on both sides of the layered prepregs, a vacuum press was performed at a pressure of 30 kg/cm² and a temperature of 210°C for 150 minutes, and copper-clad laminates (metal foil-clad laminates) with thicknesses of 0.2 mm and 0.8 mm were obtained. Using the resulting copper-clad laminate (metal foil-clad laminate), dielectric properties, alkali resistance, and desmear resistance were evaluated. The results are shown in Table 1.

### Dielectric properties

Using a test piece prepared by removing the copper foil of the copper-clad laminate with a thickness of 0.8 mm, a dielectric constant and a dielectric loss tangent at 10 GHz was measured five times by a cavity resonator perturbation method (Agilent 8722ES available from Agilent Technologies). For the evaluation of the dielectric constant, the test piece was rated A with the average of the dielectric constant of less than 3.4, B with the average of not less than 3.4 and less than 3.5, and C with the average of not less than 3.5. For the evaluation of the dielectric loss tangent, the test piece was rated A with the average of the dielectric loss tangent of less than 0.0026, B with the average of not less than 0.0026 and less than 0.003, and C with the average of not less than 0.003.

### Desmear resistance

The copper foil of the copper-clad laminate with a thickness of 0.2 mm was removed by etching, the resulting laminate was formed into a 5 cm x 5 cm sample, and the mass was measured. Thereafter, the laminate was immersed in Swelling Dip Securiganth P of Atotech Japan K.K., which is a swelling liquid, at 80°C for 10 minutes, then immersed in Concentrate Compact CP of Atotech Japan K.K., which is a roughening liquid, at 80°C for 8 minutes, and finally immersed in Reduction Conditioner Securiganth P500 of Atotech Japan K.K., which is a neutralization liquid, at 45°C for 10 minutes. The mass of the laminate after this treatment was performed three times was measured, and the mass loss (mass%) of the laminate before and after the treatment was calculated. For the evaluation of the desmear resistance, the sample was rated A with a mass loss of less than 4 mass%, B with a mass loss of not less than 4 mass% and less than 7 mass%, and C with a mass loss of not less than 7 mass%.

### Alkali resistance

The copper foil of the copper-clad laminate with a thickness of 0.2 mm was removed by etching, the resulting laminate was formed into a 5 cm x 5 cm sample, and the mass was measured. Thereafter, the mass of the laminate after immersion in a 1 N sodium hydroxide solution at 70°C for 60 minutes was measured, and the mass loss (mass%) of the laminate before and after the treatment was calculated. For the evaluation of the alkali resistance, the sample was rated A with a mass loss of less than 4 mass%, B with a mass loss of not less than 4 mass% and less than 7 mass%, and C with a mass loss of not less than 7 mass%.

### Example 2

A varnish was obtained by mixing 10 parts by mass of the styrene-butadiene-styrene block copolymer (TR2630), 20 parts by mass of the α-methylstyrene polymer (Crystalex 3085), 15 parts by mass of the maleimide compound (BMI-2300) used in Example 1, 35 parts by mass of the cyanate ester compound (SNCN) obtained from Synthesis Example 1, and 150 parts by mass of a spherical silica (SC2050-MB), and additionally 20 parts by mass of a polyphenylene ether of Formula (11) in which X is Formula (12) and -(Y-O)ₘ- is formed by polymerization of a structural unit of Formula (15) (OPE-2St1200 available from Mitsubishi Gas Chemical Company, Inc., number average molecular weight of 1187, vinyl group equivalent of 590 g/eq., and minimum melt viscosity of 1000 Pa•s), and diluting the solids with methyl ethyl ketone to 65 mass%. Various property tests were performed in the same manner as in Example 1 except for using this varnish. The physical property values of the resulting copper-clad laminates are shown in Table 1.

### Comparative Example 1

A varnish was obtained by mixing 30 parts by mass of the maleimide compound (BMI-2300) used in Example 1, 70 parts by mass of the cyanate ester compound (SNCN) obtained from Synthesis Example 1, and 150 parts by mass of a spherical silica (SC2050-MB), and diluting the solids with methyl ethyl ketone to 65 mass%. Various property tests were performed in the same manner as in Example 1 except for using this varnish. The physical property values of the resulting copper-clad laminates are shown in Table 1.

### Comparative Example 2

A varnish was obtained by mixing 10 parts by mass of the styrene-butadiene-styrene block copolymer (TR2630) used in Example 1, 27 parts by mass of the maleimide compound (BMI-2300) used in Example 1, 63 parts by mass of the cyanate ester compound (SNCN) obtained from Synthesis Example 1, and 150 parts by mass of a spherical silica (SC2050-MB), and diluting the solids with methyl ethyl ketone to 65 mass%. Various property tests were performed in the same manner as in Example 1 except for using this varnish. The physical property values of the resulting copper-clad laminates are shown in Table 1.

**[Table 1]**

| Evaluation item | Comparative Example 1 | Comparative Example 2 | Example 1 | Example 2 |
|---|---|---|---|---|
| Dielectric constant | C | C | B | A |
| Dielectric loss tangent | C | C | B | A |
| Alkali resistance | A | C | B | A |
| Desmear resistance | A | C | B | A |

As can be seen from Table 1, Examples 1 and 2 according to the present invention are excellent in dielectric properties, alkali resistance and desmear resistance. On the other hand, none of the resin compositions of Comparative Examples has a balance in terms of all of the dielectric properties, alkali resistance, and desmear resistance, and the resin compositions of Comparative Examples are inferior in any of the properties.

From the above, the laminate formed of the prepreg obtained according to the present invention was confirmed to be excellent in dielectric properties, alkali resistance, and desmear resistance.

## Claims

1. A resin composition containing a styrene-based elastomer (A), a styrene oligomer (B), a maleimide compound (C), and a cyanate ester compound (D), wherein the styrene-based elastomer (A) is at least one selected from the group consisting of a styrene-butadiene-styrene block copolymer, a styrene-isoprene-styrene block copolymer, a styrene-hydrogenated butadiene-styrene block copolymer, a styrene-hydrogenated isoprene-styrene block copolymer, and a styrene-hydrogenated (isoprene/butadiene)-styrene block copolymer.

2. The resin composition according to claim 1, wherein a content of the styrene-based elastomer (A) is from 1 to 30 parts by mass relative to 100 parts by mass of resin solid component.

3. The resin composition according to claim 1 or 2, wherein a content of the styrene oligomer (B) is from 1 to 30 parts by mass relative to 100 parts by mass of resin solid component.

4. The resin composition according to any one of claims 1 to 3, further containing a polyphenylene ether (E).

5. The resin composition according to claim 4, wherein the polyphenylene ether (E) is represented by Formula (1) and has a number average molecular weight of not lower than 1000 and not higher than 7000 and a minimum melt viscosity of not higher than 50000 Pa•s,
wherein the number average molecular weight is measured using gel permeation chromatography,
and wherein the minimum melt viscosity is measured using a dynamic viscoelasticity measuring device: 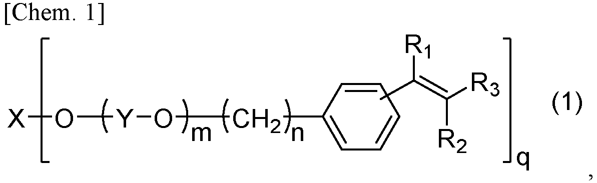
in Formula (1), X represents an aryl group; -(Y-O)ₘ- represents a polyphenylene ether moiety; R₁, R₂, and R₃ each independently represent a hydrogen atom, an alkyl group, an alkenyl group, or an alkynyl group; m represents an integer of from 1 to 100; n represents an integer of from 1 to 6; and q represents an integer of from 1 to 4.

6. The resin composition according to claim 4, wherein the polyphenylene ether compound (E) is represented by Formula (11): 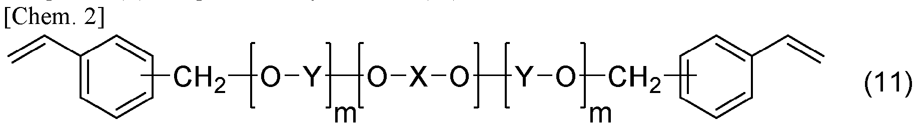
in Formula (11), X is an aromatic group selected from groups represented by Formula (12), Formula (13), and Formula (14); each -(Y-O)ₘ- represents a polyphenylene ether moiety; and each m represents an integer of from 1 to 100; 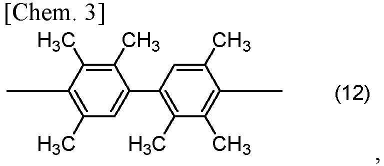 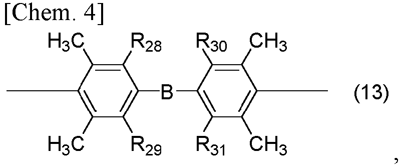
in Formula (13), R₂₈, R₂₉, R₃₀, and R₃₁ each independently represent a hydrogen atom or a methyl group; and -B- is a linear, branched, or cyclic divalent hydrocarbon group having 20 or less carbon atoms; and 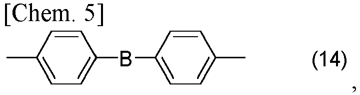
in Formula (14), -B- is a linear, branched, or cyclic divalent hydrocarbon group having 20 or less carbon atoms.

7. The resin composition according to any one of claims 1 to 6, further containing an inorganic filler (F).

8. The resin composition according to claim 7, wherein a content of the inorganic filler (F) is from 50 to 1600 parts by mass relative to 100 parts by mass of resin solid component.

9. A prepreg comprising:
a substrate, and
a layer formed from a resin composition described in any one of claims 1 to 8.

10. A metal foil-clad laminate comprising:
one or more laminated prepregs described in claim 9, and
a metal foil disposed on one side or both sides of the laminated prepregs.

11. A resin sheet comprising a layer formed from a resin composition described in any one of claims 1 to 8.

12. A resin sheet comprising:
a support, and
a layer disposed on the support, the layer being formed from a resin composition described in any one of claims 1 to 8.

13. A printed wiring board comprising an insulating layer and a conducting layer disposed on a surface of the insulating layer, wherein
the insulating layer comprises a layer formed from a resin composition described in any one of claims 1 to 8.

## Patentansprüche

1. Harzzusammensetzung, die ein Styrol-basiertes Elastomer (A), ein Styrol-Oligomer (B), eine Maleimidverbindung (C) und eine Cyanatesterverbindung (D) enthält, wobei das Styrolbasierte Elastomer (A) mindestens eines ist, ausgewählt aus der Gruppe bestehend aus einem Styrol-Butadien-Styrol-Blockcopolymer, einem Styrol-Isopren-Styrol-Blockcopolymer, einem Styrol-hydriertes Butadien-Styrol-Blockcopolymer, einem Styrol-hydriertes Isopren-Styrol-Blockcopolymer und einem Styrol-hydriertes (Isopren/Butadien)-Styrol-Blockcopolymer.

2. Harzzusammensetzung gemäß Anspruch 1, wobei ein Gehalt des Styrol-basierten Elastomers (A) 1 bis 30 Masseteile, bezogen auf 100 Masseteile der Harzfeststoffkomponente, beträgt.

3. Harzzusammensetzung gemäß Anspruch 1 oder 2, wobei der Gehalt an Styrol-Oligomer (B) 1 bis 30 Masseteile, bezogen auf 100 Masseteile der Harzfeststoffkomponente, beträgt.

4. Harzzusammensetzung gemäß mindestens einem der Ansprüche 1 bis 3, die ferner einen Polyphenylenether (E) enthält.

5. Harzzusammensetzung gemäß Anspruch 4, wobei der Polyphenylenether (E) durch die Formel (1) dargestellt ist und ein zahlenmittleres Molekulargewicht von nicht weniger als 1000 und nicht mehr als 7000 und eine Mindestschmelzviskosität von nicht mehr als 50000 Pa·s aufweist,
wobei das zahlenmittlere Molekulargewicht mittels Gelpermeationschromatographie gemessen wird,
und wobei die Mindestschmelzviskosität unter Verwendung eines dynamischen Viskoelastizitätsmessgeräts gemessen wird: 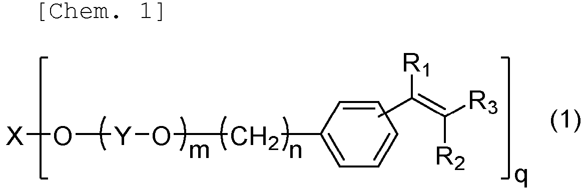
in Formel (1) steht X für eine Arylgruppe; -(Y-O)ₘ-steht für eine Polyphenylenethereinheit; R₁, R₂ und R₃ stehen jeweils unabhängig voneinander für ein Wasserstoffatom, eine Alkylgruppe, eine Alkenylgruppe oder eine Alkinylgruppe; m steht für eine ganze Zahl von 1 bis 100; n steht für eine ganze Zahl von 1 bis 6; und q steht für eine ganze Zahl von 1 bis 4.

6. Harzzusammensetzung gemäß Anspruch 4, wobei die Polyphenylenetherverbindung (E) durch die Formel (11) dargestellt ist: 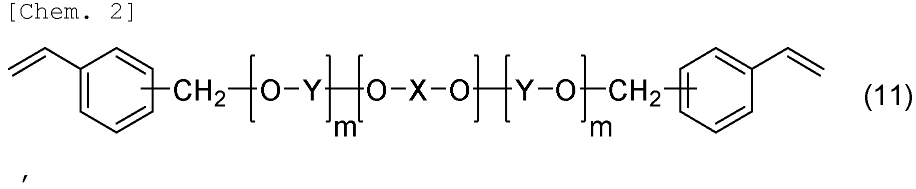
in Formel (11) ist X eine aromatische Gruppe, die aus Gruppen mit Formel (12), Formel (13) und Formel (14) ausgewählt ist; jedes -(Y-O)ₘ- steht für eine Polyphenylenethereinheit; und jedes m steht für eine ganze Zahl von 1 bis 100; 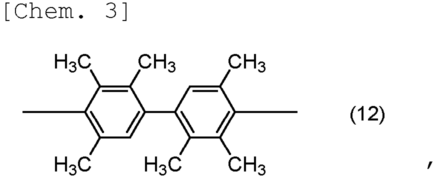 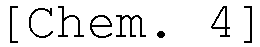 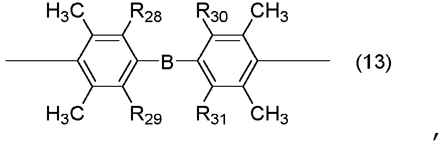
in Formel (13) stehen R₂₈, R₂₉, R₃₀ und R₃₁ jeweils unabhängig voneinander für ein Wasserstoffatom oder eine Methylgruppe; und -B- ist eine lineare, verzweigte oder cyclische zweiwertige Kohlenwasserstoffgruppe mit 20 oder weniger Kohlenstoffatomen; und 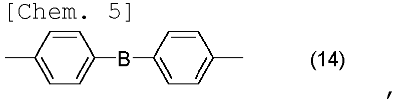
in Formel (14) ist -B- eine lineare, verzweigte oder cyclische zweiwertige Kohlenwasserstoffgruppe mit 20 oder weniger Kohlenstoffatomen.

7. Harzzusammensetzung gemäß mindestens einem der Ansprüche 1 bis 6, die ferner einen anorganischen Füllstoff (F) enthält.

8. Harzzusammensetzung gemäß Anspruch 7, wobei der Gehalt des anorganischen Füllstoffs (F) zwischen 50 und 1600 Masseteilen, bezogen auf 100 Masseteile der Harzfeststoffkomponente, beträgt.

9. Prepreg, umfassend:
ein Substrat, und
eine Schicht, die aus einer in mindestens einem der Ansprüche 1 bis 8 beschriebenen Harzzusammensetzung gebildet ist.

10. Mit Metallfolie beschichtetes Laminat, umfassend:
ein oder mehrere in Anspruch 9 beschriebene laminierte Prepregs, und
eine Metallfolie, die auf einer Seite oder beiden Seiten der laminierten Prepregs angeordnet ist.

11. Harzfolie, umfassend eine Schicht, die aus einer in mindestens einem der Ansprüche 1 bis 8 beschriebenen Harzzusammensetzung gebildet ist.

12. Harzfolie, umfassend:
einen Träger, und
eine auf dem Träger angeordnete Schicht, wobei die Schicht aus einer in mindestens einem der Ansprüche 1 bis 8 beschriebenen Harzzusammensetzung gebildet ist.

13. Gedruckte Leiterplatte, die eine Isolierschicht und eine auf einer Oberfläche der Isolierschicht angeordnete leitende Schicht umfasst, wobei
die Isolierschicht eine Schicht umfasst, die aus einer in mindestens einem der Ansprüche 1 bis 8 beschriebenen Harzzusammensetzung gebildet ist.

## Revendications

1. Composition de résine contenant un élastomère à base de styrène (A), un oligomère de styrène (B), un composé maléimide (C) et un composé d'ester cyanate (D), dans laquelle l'élastomère à base de styrène (A) est au moins un élastomère sélectionné parmi le groupe consistant en un copolymère séquencé styrène-butadiène-styrène, un copolymère séquencé styrène-isoprène-styrène, un copolymère séquencé styrène-butadiène hydrogéné-styrène, un copolymère séquencé styrène-isoprène hydrogéné-styrène et un copolymère séquencé styrène-(isoprène/butadiène)-styrène hydrogéné.

2. Composition de résine selon la revendication 1, dans laquelle une teneur en élastomère à base de styrène (A) est comprise de 1 à 30 parties en masse par rapport à 100 parties en masse de composant solide de résine.

3. Composition de résine selon la revendication 1 ou 2, dans laquelle une teneur en oligomère de styrène (B) est comprise de 1 à 30 parties en masse par rapport à 100 parties en masse de composant solide de résine.

4. Composition de résine selon l'une quelconque des revendications 1 à 3, contenant en outre un éther de polyphénylène (E).

5. Composition de résine selon la revendication 4, dans laquelle l'éther de polyphénylène (E) est représenté par la formule (1) et présente une masse moléculaire moyenne en nombre non inférieure à 1 000 et non supérieure à 7 000 et une viscosité à l'état fondu minimale non supérieure à 50 000 Pa•s,
dans laquelle la masse moléculaire moyenne en nombre est mesurée en utilisant la chromatographie par perméation de gel,
et dans laquelle la viscosité à l'état fondu minimale est mesurée en utilisant un dispositif de mesure de viscoélasticité dynamique : 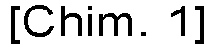 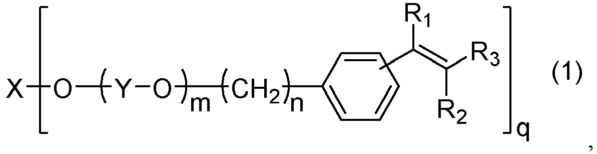
dans la formule (1), X représente un groupe aryle ; -(Y-O)ₘ- représente un groupe caractéristique d'éther de polyphénylène ; R1, R2 et R3 représentent chacun indépendamment un atome d'hydrogène, un groupe alkyle, un groupe alcényle, ou un groupe alcynyle ; m représente un nombre entier compris entre 1 et 100 ; n représente un nombre entier compris entre 1 et 6 ; et q représente an nombre entier compris entre 1 et 4.

6. Composition de résine selon la revendication 4, dans laquelle le composé d'éther de polyphénylène (E) est représenté par la formule (11) : 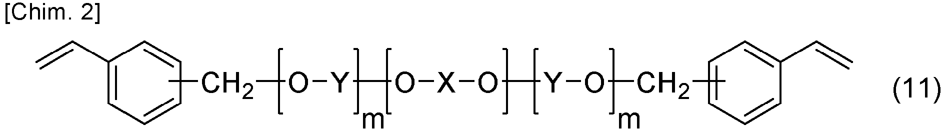
dans la formule (11), X est un groupe aromatique sélectionné parmi les groupes représentés par la formule (12), la formule (13) et la formule (14) ; chaque - (Y-O)ₘ- représente un groupe caractéristique d'éther de polyphénylène ; et chaque m représente un nombre entier compris entre 1 et 100 ; 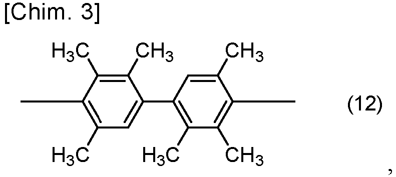 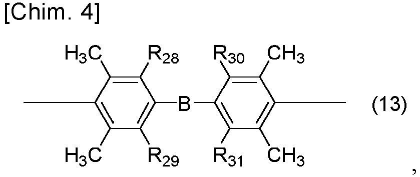
dans la formule (13), R28, R29, R30 et R31 représentent chacun indépendamment un atome d'hydrogène ou un groupe méthyle ; et -B- est un groupe d'hydrocarbures divalent linéaire, ramifié ou cyclique présentant 20 atomes de carbone ou moins ; et 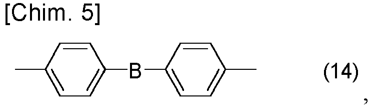
dans la formule (14), -B- est un groupe d'hydrocarbures divalent linéaire, ramifié ou cyclique présentant 20 atomes de carbone ou moins.

7. Composition de résine selon l'une quelconque des revendications 1 à 6, contenant en outre une charge inorganique (F).

8. Composition de résine selon la revendication 7, dans laquelle une teneur en charge inorganique (F) est comprise de 50 à 1 600 parties en masse par rapport à 100 parties en masse de composant solide de résine.

9. Préimprégné comprenant :
un substrat et
une couche formée à partir d'une composition de résine décrite selon l'une quelconque des revendications 1 à 8.

10. Stratifié renforcé par une feuille métallique comprenant :
un ou plusieurs préimprégnés stratifiés décrits selon la revendication 9 et
une feuille métallique disposée sur un côté ou sur les deux côtés des préimprégnés stratifiés.

11. Feuille de résine comprenant une couche formée à partir d'une composition de résine décrite selon l'une quelconque des revendications 1 à 8.

12. Feuille de résine comprenant :
un support et
une couche disposée sur le support, la couche étant formée à partir d'une composition de résine décrite selon l'une quelconque des revendications 1 à 8.

13. Carte de circuit imprimé comprenant une couche isolante et une couche conductrice disposée sur une surface de la couche isolante, dans laquelle
la couche isolante comprend une couche formée à partir d'une composition de résine décrite selon l'une quelconque des revendications 1 à 8.
